# EUROPÄISCHE PATENTSCHRIFT

(11) **EP 1 196 951 B1**
(45) Veröffentlichungstag und Bekanntmachung des Hinweises auf die Patenterteilung: **03.04.2013**
(21) Anmeldenummer: 00954331.5
(22) Anmeldetag: 13.07.2000
(51) Int. Cl.: H01L 25/10

(54) **TSOP-SPEICHERCHIPGEHÄUSEANORDNUNG**
TSOP MEMORY CHIP HOUSING ARRANGEMENT
ENSEMBLE DE BOITIERS A PUCE MEMOIRE DU TYPE BOITIER MINCE A CONNECTIONS COURTES (TSOP)

(30) Priorität: 15.07.1999 DE 19933265
(43) Veröffentlichungstag der Anmeldung: 17.04.2002
(73) Patentinhaber: Qimonda AG, 81739 München (DE)
(72) Erfinder: WÖRZ, Andreas, D-93309 Kelheim (DE); GOTTLIEB, Alfred, D-93152 Nittendorf/Undorf (DE); RÖMER, Bernd, D-93170 Bernhardswald (DE)
(74) Vertreter: Schoppe, Fritz
(86) Internationale Anmeldenummer: PCT/DE2000/002292
(87) Internationale Veröffentlichungsnummer: WO 2001/006562

(56) Entgegenhaltungen:
- US-A- 5 455 740
- US-A- 5 484 959
- US-A- 5 910 885

## Beschreibung

Die Erfindung betrifft eine Anordnung von mindestens zwei übereinander gestapelten TSOP-Speicherchipgehäusen gemäß Oberbegriff des Patentanspruchs 1.

TSOP-Speicherchipgehäuse (TSOP: Thin Small Online Package) enthalten in ihrem Inneren mindestens einen Speicherchip, der mehrere Pins aufweist, die aus dem jeweiligen TSOP-Speicherchipgehäuse herausgeführt sind. Die Speicherkapazität solcher TSOP-Speicherchipgehäuse kann durch Übereinanderstapeln von einzelnen Gehäusen vervielfacht werden. Dabei muss allerdings beachtet werden, dass gleich verdrahtete Speicherchips von unterschiedlichen Pins angesteuert werden. Es ist deshalb notwendig und auch bereits vorgeschlagen worden, eine Umverdrahtungsebene vorzusehen, die gleichzeitig die jeweiligen Pins der übereinander gestapelten Gehäuse miteinander verbindet.

Vorgeschlagen wurde bereits, solche übereinander gestapelten TSOP-Speicherchipgehäuse mit Hilfe von kleinen integrierten Schaltkreisen ("PCB-Boards" (PCB: Printed-Circuit-Board)) oder mit Hilfe von Verbindungsleitungsrahmen ("Leadframes") auf der Aussenseite der Gehäuse und mit Flexmaterialien (mit umgebogenen Beinchen) zwischen den einzelnen Gehäusen zu realisieren.

Die vorgeschlagenen Lösungen sind relativ aufwendig und für eine kostengünstige Automatisierung der Herstellung solcher Gehäusestapel nur bedingt brauchbar.

Die US-5455740 offenbart ein Buskommunikationssystem für gestapelte integrierte Schaltungsgehäuse mit hoher Dichte.

Die US-5484959 offenbart ein Fertigungsverfahren für ein Lead-On-Gehäuse mit hoher Dichte und eine entsprechende Vorrichtung.

Die der Erfindung zugrunde liegende Aufgabe besteht daher darin, eine TSOP-Speicherchipgehäuseanordnung der eingangs genannten Art zu schaffen, die kostengünstig ist in ihrer Herstellung und zudem für die automatisierte Herstellung geeignet ist.

Die erfindungsgemäße Lösung dieser Aufgabe ist durch die Merkmale des Patentanspruchs 1 wiedergegeben. Die übrigen Patentansprüche enthalten vorteilhafte Aus- und Weiterbildungen der Erfindung.

Ausgehend von einer Anordnung von mindestens zwei übereinander gestapelten TSOP-Speicherchipgehäusen mit jeweils mindestens einem im Inneren des TSOP-Speicherchipgehäuses angeordneten Speicherchip mit mehreren Pins, die aus dem jeweiligen TSOP-Speicherchipgehäuse herausgeführt sind und über eine Umverdrahtungsanordnung mit aus dem jeweils direkt benachbarten TSOP-Speicherchipgehäuse des gleichen TSOP-Speicherchipgehäusestapels herausgeführten Pins verbunden sind, sieht die Erfindung vor, dass die Umverdrahtungsanordnung in Form von jeweils zwischen den oder seitlich zwischen den einzelnen TSOP-Speicherchipgehäusen angeordneten Verbindungsleitungsrahmen realisiert ist.

Durch die Einbringung der Umverdrahtungs- bzw. Verbindungsebene mittels Verbindungsleitungsrahmen zwischen den einzelnen Gehäusen bzw. seitlich zwischen den Gehäusen ergeben sich eine Reihe von Vorteilen gegenüber den bereits vorgeschlagenen und weiter oben geschilderten anderen Lösungen:
- hohe Kosteneinsparung durch die Verwendung der an sich bekannten Verbindungsleitungstechnik,
- die Einbringung von Umverdrahtungsebenen zwischen den Gehäusen ist auf einfache Weise möglich,
- wohldefinierte Lötbereiche können auf einfache Weise festgelegt werden; eine Lotdepotauftragung ist möglich,
- seitliche Lötverfahren wie z. B. Minilotwelle realisierbar.

Im folgenden wird die Erfindung anhand der in den Figuren beschriebenen Ausführungsbeispielen näher erläutert. Es zeigen:
- Fig. 1:: ein erstes vorteilhaftes Ausführungsbeispiel der erfindungsgemäßen Anordnung im Querschnitt von der Seite
- Fig. 2:: ein Vergleichsbeispiel der erfindungsgemäßen Anordnung im Querschnitt von der Seite
- Fig. 3:: ein zweites vorteilhaftes Ausführungsbeispiel der erfindungsgemäßen Anordnung im Querschnitt von der Seite
- Fig. 4:: ein Vergleichsbeispiel im Querschnitt von der Seite
- Fig. 5:: die Anordnung gemäß Fig. 4 im Ausschnitt und um die vertikale Achse um 90 Grad gedreht von der Seite
- Fig. 6:: ein weiteres Vergleichsbeispiel im Querschnitt von der Seite
- Fig. 7:: die Anordnung gemäß Fig. 6 im Ausschnitt und um die vertikale Achse um 90 Grad gedreht von der Seite
- Fig. 8:: eine vorteilhafte Ausführungsform eines Trägers von oben mit mehreren nebeneinander angeordneten Verbindungsleitungsrahmen nach der Erfindung
- Fig. 9:: den Verbindungsleitungsrahmen gemäß Fig. 8 von der Seite mit montierten TSOP-Speicherchipgehäusepaaren
- Fig. 10:: ein drittes vorteilhaftes Ausführungsbeispiel der erfindungsgemäßen Anordnung im Querschnitt von der Seite
- Fig. 11:: einen Träger mit mehreren Verbindungsleitungsrahmen und TSOP-Speicherchipgehäusestapeln gemäß Fig. 10 von der Seite
- Fig. 12:: die Anordnung gemäß Fig. 10 bzw. Fig. 11 um die vertikale Achse um 90 Grad gedreht von der Seite.

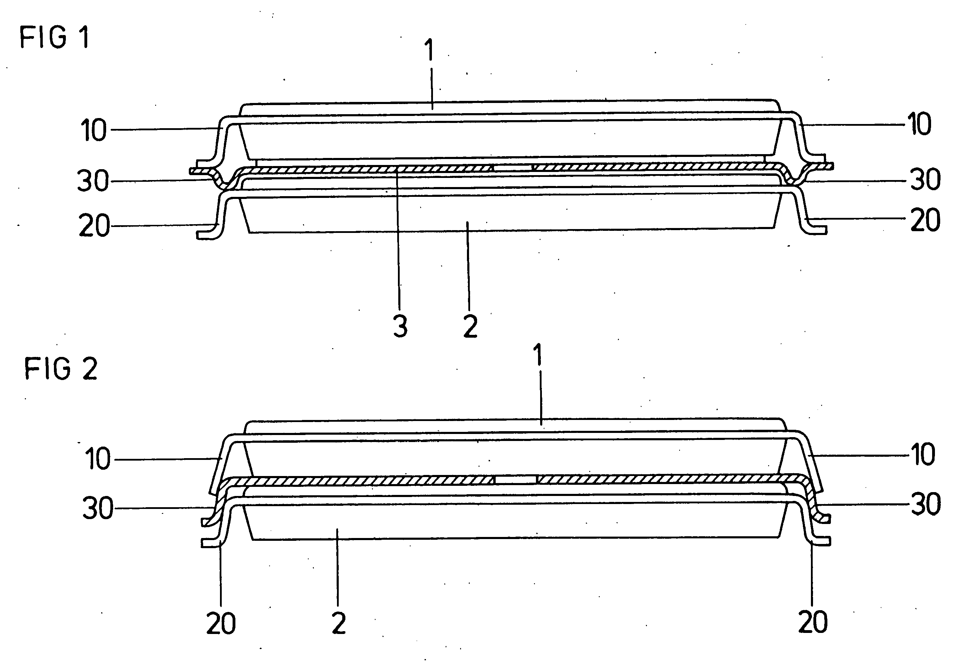

In den einzelnen Fig. 1 bis 12 sind gleiche Teile jeweils mit dem gleichen Bezugszeichen versehen.

Die Anordnung in Fig. 1 zeigt im Querschnitt von der Seite zwei übereinander gestapelte TSOP-Speicherchipgehäuse 1 und 2, deren aus dem Gehäuse 1, 2 herausragende Pins 10 und 20 im Querschnitt s-förmig (Fachbegriff: "gull-wing"-förmig) gebogen sind, im Raum parallel zueinander ausgerichtet sind und durch einen als Umverdrahtungs- und Verbindungsanordnung dienenden Verbindungsleitungsrahmen 3 miteinander verbunden sind, und zwar dergestalt, dass die einzelnen Verbindungsleitungen des Verbindungsleitungsrahmens 3 an ihren freien Enden 30 im Querschnitt u-förmig geformt sind, so dass die einzelnen Pins 10 des oberen Gehäuses 1 mit dem jeweiligen äußeren Schenkel des u-förmig gebogenen freien Endes 30 der zugehörigen Verbindungsleitung verbunden sind und die einzelnen Pins 20 des unteren Gehäuses 2 mit dem jeweiligen u-Bogen des freien Endes 30 der zugehörigen Verbindungsleitung verbunden sind.

Der wesentliche Vorteil dieser Anordnung ist darin zu sehen, dass an den miteinander zu verbindenden Gehäusen 1 und 2 keine zusätzlichen Beinchen- bzw. Pin-Biegungen erforderlich sind.

Die Anordnung des Vergleichsbeispiels gemäß Fig. 2 unterscheidet sich von der Anordnung in Fig. 1 dadurch, dass in Fig. 2 die freien Enden 30 der einzelnen Verbindungsleitungen des Verbindungsleitungsrahmens 3 ebenso wie die Pins 20 des unteren TSOP-Speicherchipgehäuses 2 im Querschnitt s-förmig gebogen sind und im Raum parallel zueinander ausgerichtet sind. Bei diesem Aufbau reicht eine einfache nach unten gerichtete Biegung der Pins 10 des oberen TSOP-Speicherchipgehäuses 1 aus, um die gewünschte Verbindung zwischen den Pins 10, 20 der beiden Gehäuse 1, 2 herstellen zu können.

Der wesentliche Vorteil dieser Anordnung ist darin zu sehen, dass die Pins des oberen Gehäuses nur einfach gebogen werden müssen.

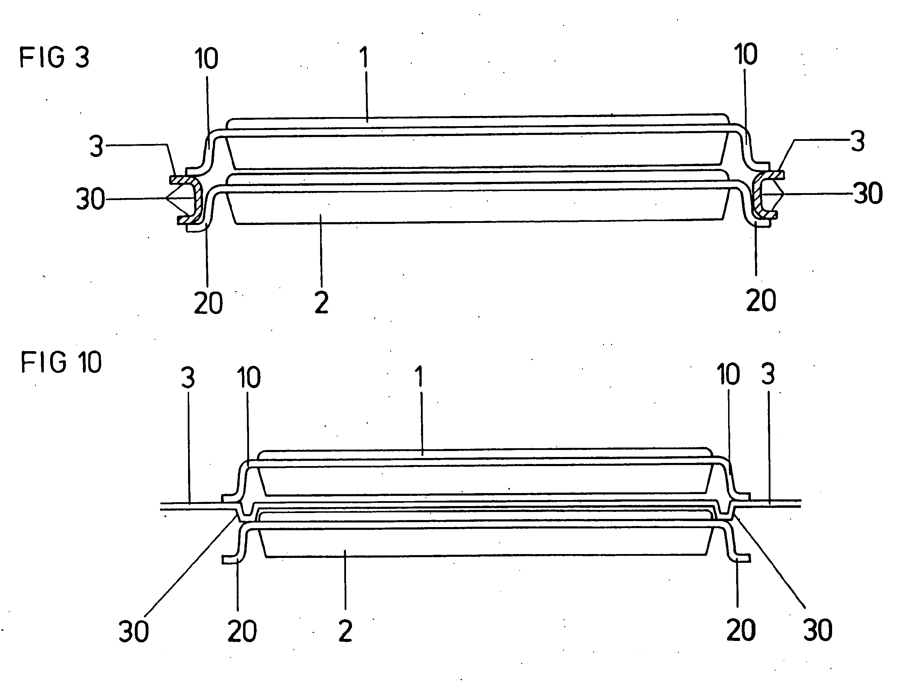

Die Anordnung gemäß Fig. 3 zeigt zwei übereinander gestapelte TSOP-Speicherchipgehäuse 1 und 2 im Querschnitt von der Seite, deren Pins 10, 20 über einen seitlich zwischen den Gehäusen 1, 2 angeordneten Verbindungsleitungsrahmen 3 miteinander verbunden sind. Die einzelnen Verbindungsleitungen des Rahmens 3 sind dabei im Querschnitt u-förmig ausgebildet und derart im Raum ausgerichtet, dass die freien Enden der jeweiligen Verbindungsleitung, d. h. die Schenkel der einzelnen "u"-s die zugehörigen Pins 10, 20 der beiden Gehäuse 1, 2 miteinander verbinden.

Der wesentliche Vorteil dieser Anordnung besteht darin, dass an den zu verbindenden Gehäusen 1, 2 keine zusätzlichen Beinchen-, d. h. Pin-Biegungen erforderlich sind (vergleichbar zur Anordnung gemäß Fig. 1).

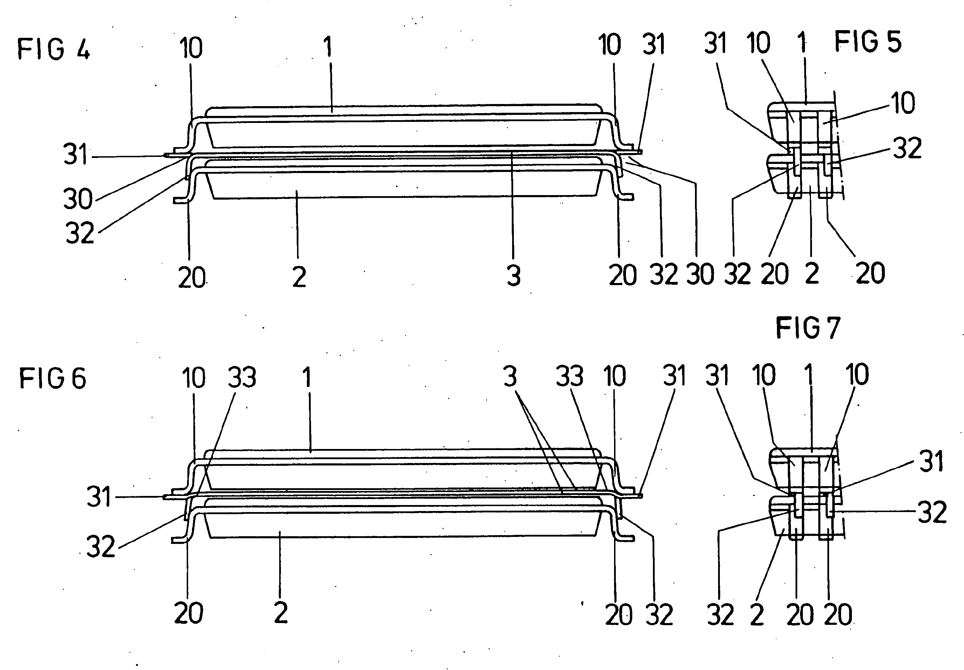

Die Anordnung eines Vergleichsbeispiels gemäß Fig. 4 und Fig. 5 zeigt ebenfalls zwei übereinander gestapelte TSOP-Speicherchipgehäuse 1 und 2 im Querschnitt von der Seite, deren Pins 10, 20 über einen zwischen den Gehäusen 1, 2 angeordneten Verbindungsleitungsrahmen 3 miteinander verbunden sind. Die einzelnen Verbindungsleitungen des Rahmens 3 sind dabei an ihren freien Enden 30 in Längsrichtung aufgespalten, wobei die eine Hälfte 31 sich horizontal (ohne Biegung nach oben oder unten) erstreckt, während die andere Hälfte 32 nach unten abgebogen ist. Die beiden Teile 31 und 32 der freien Enden 30 der einzelnen Verbindungsleitungen des Verbindungsleitungsrahmens 3 sind dabei so angeordnet, dass die horizontal ausgerichteten Teile 31 der freien Enden 30 die Pins 10 des oberen Gehäuses 1 kontaktieren, während die nach unten gebogenen Teile 32 der freien Enden 30 die Pins 20 des unteren Gehäuses 2 kontaktieren.

Der wesentliche Vorteil dieser Anordnung ist darin zu sehen, dass, ähnlich wie bei den Anordnungen gemäß Fig. 1 und Fig. 3, an den zu verbindenden Gehäusen 1, 2 keine zusätzlichen Beinchen-, d. h. Pin-Biegungen erforderlich sind.

Die Anordnung gemäß Fig. 6 und Fig. 7 unterscheidet sich von der Anordnung gemäß Fig. 4 und Fig. 5 lediglich dadurch, dass die Verbindungsleitungen des Verbindungsleitungsrahmens 3 vor ihren jeweils in zwei Teile 31, 32 aufgespaltenen freien Enden 30 nach unten abgeknickt sind und im Knickbereich 33 im Querschnitt jeweils s-förmig ausgebildet sind.

Der wesentliche Vorteil dieser Anordnung ist darin zu sehen, dass der horizontal ausgerichtete Teil 31 der freien Enden 30 der einzelnen Verbindungsleitungen des Verbindungsleitungsrahmens 3 gegenüber der Anordnung gemäß Fig. 4 und Fig. 5 herabgesetzt ("tiefer gelegt") ist, wodurch der Abstand der Gehäuseunterseite des oberen Gehäuses 1 zum Verbindungsleitungsrahmen 3 derart verkleinert wird, dass eine zuverlässige Klebeverbindung des oberen Gehäuses 1 mit dem Rahmen 3 ohne weiteres realisiert werden kann.

Generell zeichnen sich die Anordnungen gemäß der Fig. 1 bis Fig. 3 dadurch aus, dass die TSOP-Speicherchipgehäuse 1, 2 auf sehr einfache Art montiert werden können, dass Formschluss und Selbstjustage der gesamten Anordnung bei der Montage ohne zusätzlichen Aufwand möglich ist und dass eine automatisierte Montage ohne weiteres realisiert werden kann. Die Anordnungen der Vergleichsbeispiele gemäß Fig. 4 bis Fig. 7 zeichnen sich ferner dadurch aus, dass die Selbstjustage besonders einfach zu realisieren ist und ein mechanische Befestigung des Verbindungsleitungsrahmens 3 mit den beiden Gehäusen 1, 2 besonders einfach hergestellt werden kann.

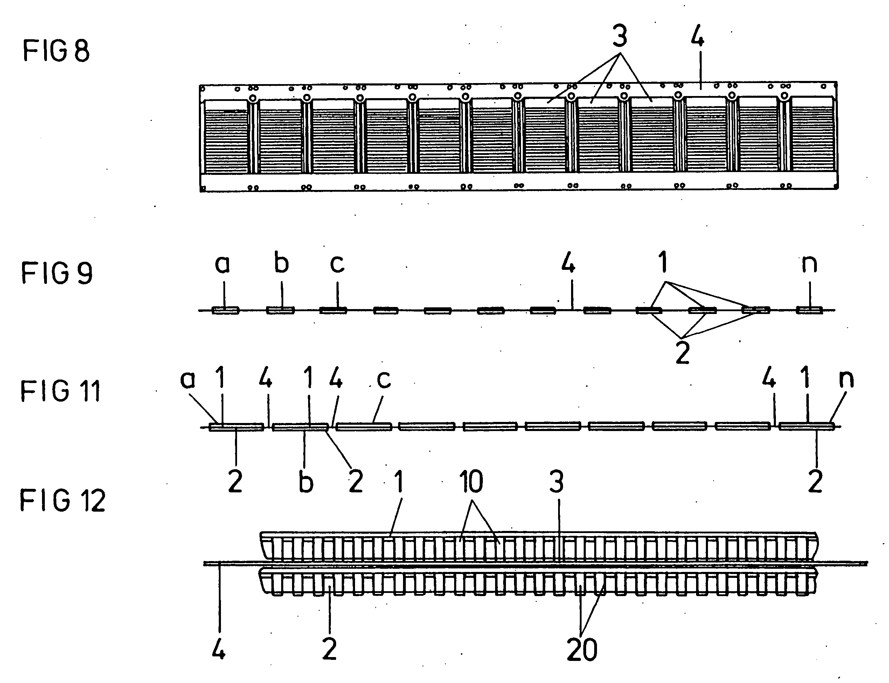

In Fig. 8 ist eine aus mehreren nebeneinander angeordneten Verbindungsleitungsrahmen 3 bestehende Rahmenanordnung, d. h. ein Träger 4 für mehrere solcher Rahmen 3 von oben gezeigt. Der Träger ist hier in Fig. 8 so gestaltet, dass die TSOP-Speicherchipgehäuse parallel zur Stirnseite des Trägers 4 montiert werden können.

Fig. 9 zeigt den Träger 4 von der Seite mit mehreren Stapeln a-n von montierten TSOP-Speicherchipgehäusepaaren 1 und 2, die durch einen jeweils dazwischen liegenden Verbindungsrahmen miteinander verbunden sind.

Die Anordnung in Fig. 10 zeigt, ähnlich zu der Anordnung gemäß Fig. 1, im Querschnitt von der Seite zwei übereinander gestapelte TSOP-Speicherchipgehäuse 1 und 2, deren aus dem Gehäuse 1, 2 herausragende Pins 10 und 20 im Querschnitt s-förmig (Fachbegriff: "gull-wing"-förmig) gebogen sind, im Raum parallel zueinander ausgerichtet sind und durch einen als Umverdrahtungs- und Verbindungsanordnung dienenden Verbindungsleitungsrahmen 3 miteinander verbunden sind, und zwar dergestalt, dass die einzelnen Verbindungsleitungen des Verbindungsleitungsrahmens 3 an ihren freien Enden 30 im Querschnitt nut-förmig geformt sind, so dass die einzelnen Pins 10 des oberen Gehäuses 1 mit dem jeweiligen äußeren Schenkel des nut-förmig gebogenen freien Endes 30 der zugehörigen Verbindungsleitung verbunden sind und die einzelnen Pins 20 des unteren Gehäuses 2 mit dem Boden der jeweiligen Nut des freien Endes 30 der zugehörigen Verbindungsleitung verbunden sind.

Der wesentliche Vorteil dieser Anordnung ist, wie bei den Anordnungen gemäß Fig. 1, Fig. 3, Fig. 4, darin zu sehen, dass an den miteinander zu verbindenden Gehäusen keine zusätzlichen Beinchen- bzw. Pin- Biegungen erforderlich sind.

Fig. 11 zeigt mehrere solcher Gehäuse/Rahmen-Anordnungen a-n gemäß Fig. 10 nebeneinander auf einem gemeinsamen Träger 4 parallel zur Längsseite angeordnet, und zwar von der Seite.

Fig. 12 schließlich zeigt eine vergrößerte Seitenansicht der Anordnung gemäß Fig. 10, die um die vertikale Achse um 90 Grad gegenüber der Ansicht gemäß Fig. 10 gedreht ist.

Die Anordnungen gemäß Fig. 8 bis Fig. 12 zeichnen sich vor allem dadurch aus, dass mit ihnen besonders einfach eine kostengünstige und damit industriell interessante automatisierte Nutzenmontage möglich ist.

Die Erfindung ist nicht auf die in den Figuren dargestellten Ausführungsbeispiele beschränkt, sondern vielmehr auf weitere übertragbar.

So ist es z. B. möglich, mehr als zwei TSOP-Speicherchipgehäuse übereinander zu stapeln mit jeweils einem dazwischen oder seitlich dazwischen liegenden Verbindungsleitungsrahmen.

Schließlich ist es möglich mehrere solcher Stapel in Form eines zweidimensionalen Stapelfeldes auf einem gemeinsamen Träger anzuordnen.

## Patentansprüche

1. Anordnung von mindestens zwei übereinander gestapelten TSOP-Speicherchipgehäusen mit jeweils mindestens einem im Inneren des TSOP-Speicherchipgehäuses angeordneten Speicherchip mit mehreren Pins, die aus dem jeweiligen TSOP-Speicherchipgehäuse herausgeführt sind und über eine Umverdrahtungsanordnung in Form von jeweils zwischen den oder seitlich zwischen den einzelnen TSOP-Speicherchipgehäusen (1, 2) angeordneten Verbindungsleitungsrahmen (3) mit aus dem jeweils direkt benachbarten TSOP-Speicherchipgehäuse des gleichen TSOP-Speicherchipgehäusestapels herausgeführten Pins verbunden sind, wobei Pins (10, 20) an ihren aus den TSOP-Speicherchipgehäusen (1, 2) herausgeführten Enden im Querschnitt s- oder stufenförmig ausgebildet sind oder nach unten oder oben abgeknickt sind und wobei übereinander angeordnete Pins (10, 20) der übereinander gestapelten TSOP-Speicherchipgehäuse (1, 2) mit im Querschnitt gleicher Kontur vorzugsweise parallel zueinander im Raum ausgerichtet sind, wobei die freien Enden (30) der einzelnen Verbindungsleitungen des Verbindungsleitungsrahmens (3) jeweils im Querschnitt nut- oder trog- oder u- oder v-förmig ausgebildet sind oder wobei die freien Enden bei u-förmigen Verbindungsleitungen von Verbindungsleitungsrahmen, die seitlich zwischen den einzelnen TSOP-Speicherchipgehäusen angeordnet sind, als deren Schenkel ausgebildet sind, **dadurch gekennzeichnet, dass** die einzelnen ungespaltenen Verbindungsleitungen des Verbindungsleitungsrahmens (3) an ihren freien Enden (30) so geformt sind, dass sie jeweils direkt übereinanderliegende Pins (10, 20) der direkt benachbarten TSOP-Speicherchipgehäuse (1, 2) miteinander verbinden.

2. Anordnung nach Anspruch 1, **dadurch gekennzeichnet, dass** mindestens zwei Stapel (a-n) von mindesten zwei übereinander angeordneten TSOP-Speichergehäusen (1, 2) nebeneinander angeordnet sind und dass die Verbindungsleitungsrahmen (3) der einzelnen TSOP-Speichergehäusestapel (a-n) auf einem gemeinsamen Träger (4) angeordnet sind.

3. Anordnung nach einem der vorhergehenden Ansprüche, **dadurch gekennzeichnet, dass** ein Teil oder alle TSOP-Speicherchipgehäuse (1, 2) mit dem jeweils dazwischen liegenden Verbindungsleitungsrahmen (3) mechanisch verbunden sind und dass diese mechanische Verbindung vorzugsweise eine Klebeverbindung ist.

4. Anordnung nach einem der vorhergehenden Ansprüche, **dadurch gekennzeichnet, dass** die Pins (10, 20) mit den zugehörigen freien Enden (30) der Verbindungsleitungen des jeweiligen Verbindungsleitungsrahmens (3) verlötet oder verschweißt sind.

## Claims

1. Arrangement of at least two TSOP memory chip housings stacked upon each other and each having at least one memory chip which is arranged inside the TSOP memory chip housing and comprises several pins emerging from the respective TSOP memory chip housing and connected - via a rewiring arrangement in the form of connecting lead frames (3) arranged between, or laterally between, the individual TSOP memory chip housings (1, 2) in each case - to pins emerging from the respectively directly adjacent TSOP memory chip housing of the same TSOP memory chip housing stack, wherein pins (10, 20) are configured, at their ends emerging from the TSOP memory chip housings (1, 2), in an s-or step-shaped manner in their cross sections or are angulated toward the top or bottom, and wherein stacked pins (10, 20) of the stacked TSOP memory chip housings (1, 2) are aligned in parallel with one another within the space, wherein the free ends (30) of the individual connecting leads of the connecting lead frame (3) with contours equal in cross section are configured in the shape of a groove or trough or of a u or v in their cross sections in each case, or wherein the free ends are configured - in the case of u-shaped connecting leads of connecting lead frames arranged laterally between the individual TSOP memory chip housings - as their legs, **characterized in that** the individual non-split connecting leads of the connecting lead frame (3) are formed, at their free ends (30), such that they connect pins (10, 20), which lie directly on top of one other in each case, of the directly adjacent TSOP memory chip housings (1, 2) with one another.

2. Arrangement as claimed in claim 1, **characterized in that** at least two stacks (a-n) of at least two TSOP memory housings (1, 2) arranged one above the other are arranged adjacently and that the connecting lead frames (3) of the individual TSOP memory housing stacks (a-n) are arranged on a common carrier (4).

3. Arrangement as claimed in any of the previous claims, **characterized in that** some or all of the TSOP memory chip housings (1, 2) are mechanically connected to the connecting lead frame (3) interjacent in each case, and that this mechanical connection preferably is a bonded connection.

4. Arrangement as claimed in any of the previous claims, **characterized in that** the pins (10, 20) are soldered or welded to the associated free ends (30) of the connecting leads of the respective connecting lead frame (3).

## Revendications

1. Ensemble d'au moins deux boîtiers à puce mémoire du type boîtier mince à connexions courtes (TSOP) empilés l'un au-dessus de l'autre, chacun avec au moins une puce mémoire à plusieurs broches disposée à l'intérieur du boîtier à puce mémoire TSOP, lesquelles broches ressortent du boîtier à puce mémoire TSOP et sont reliées, par l'intermédiaire d'un aménagement de câblage sous forme de grilles de conducteurs de connexion (3), disposées respectivement entre les ou latéralement entre les boîtiers à puce mémoire TSOP individuels (1, 2), à des broches ressortant du boîtier à puce mémoire TSOP immédiatement adjacent, respectivement, de la même pile de boîtiers à puce mémoire TSOP, les broches (10, 20) étant réalisées, à leurs extrémités ressortant des boîtiers à puce mémoire TSOP (1, 2), à section en forme de s ou en forme de marche ou recourbées vers le bas ou vers le haut et les broches (10, 20) disposées l'une au-dessus de l'autre des boîtiers à puce mémoire TSOP (1, 2) empilés l'un au-dessus de l'autre à même contour en section étant de préférence orientées parallèles entre elles dans l'espace, les extrémités libres (30) des circuits de connexion individuels de la grille de circuits de connexion (3) étant réalisées, chacune, à section en forme de rainure ou d'auge ou de u ou de v ou les extrémités libres étant réalisées, dans le cas de circuits de connexion en forme de u de grilles de circuits de connexion disposés latéralement entre les boîtiers à puce mémoire TSOP individuels, comme les branches de ces derniers, **caractérisé par le fait que** les circuits de connexion non divisés individuels de la grille de circuits de connexion (30) sont formés, à leurs extrémités libres (30), de sorte qu'ils relient, chacun, l'une à l'autre les broches (10, 20) immédiatement disposées l'une au-dessus de l'autre des boîtiers à puce mémoire TSOP (1, 2) immédiatement adjacents.

2. Ensemble selon la revendication 1, **caractérisé par le fait qu'**au moins deux piles (a-n) d'au moins deux boîtiers mémoire TSOP (1, 2) disposés l'un au-dessus de l'autre sont disposées l'une à côté de l'autre et que les grilles de circuits de connexion (3) des piles de boîtiers mémoire TSOP individuelles (a-n) sont disposées sur un support commun (4).

3. Ensemble selon l'une des revendications précédentes, **caractérisé par le fait qu'**une partie des ou tous les boîtiers à puce mémoire TSOP (1, 2) sont connectés mécaniquement à la grille de circuits de connexion (3) située entre eux et que cette connexion mécanique est de préférence un assemblage par collage.

4. Ensemble selon l'une des revendications précédentes, **caractérisé par le fait que** les broches (10, 20) sont brasées ou soudées aux extrémités libres (30) respectives des circuits de connexion de la grille de circuits de connexion (3) respective.
